# EUROPEAN PATENT APPLICATION

(11) **EP 4 851 646 A1**
(43) Date of publication of application: **09.12.2026**
(21) Application number: 26173355.4
(22) Date of filing: 20.04.2026
(51) Int. Cl.: G01R 31/367, G01R 31/374, G01R 31/392, G01R 31/3842

(54) **METHOD FOR ESTIMATING AVAILABLE ENERGY OF SECONDARY BATTERY, STORAGE MEDIUM, DEVICE FOR ESTIMATING AVAILABLE ENERGY OF SECONDARY BATTERY, AND BATTERY SYSTEM**

(30) Priority: 13.05.2025 JP 2025080442
(71) Applicant: Prime Planet Energy & Solutions, Inc., Chuo-ku, Tokyo 103-0022 (JP)
(72) Inventor: TANAKA, Yasuharu, Tokyo, 103-0022 (JP)
(74) Representative: Kuhnen & Wacker Patent- und Rechtsanwaltsbüro PartG mbB

(57) **Abstract**

The method for estimating available energy of a secondary battery includes a process of acquiring a change amount of a capacity retention rate, a process of estimating a change amount of an initial available energy ratio, and a process of estimating available energy. In the process of acquiring the change amount of the capacity retention rate, the change amount of the capacity retention rate is acquired based on predetermined information acquired from the secondary battery. In the process of estimating the change amount of the initial available energy ratio, the change amount of the initial available energy ratio is estimated by multiplying the change amount of the capacity retention rate by a coefficient K. In the process of estimating the available energy, the available energy is estimated based on the estimated change amount of the initial available energy ratio.

## Description

### BACKGROUND OF THE DISCLOSURE

The present disclosure relates to a method for estimating available energy of a secondary battery, a program, a device for estimating available energy of a secondary battery, and a battery system.

Japanese Patent Application Laid-Open No. 2018-169238 discloses a power storage control device capable of calculating a full charge capacity of a storage battery. The power storage control device calculates a full charge capacity of the storage battery based on a first remaining capacity calculated based on an open circuit voltage at a first measurement timing, a second remaining capacity calculated based on an open circuit voltage at a second measurement timing, an integrated capacity at the first measurement timing, and an integrated capacity at the second measurement timing. The power storage control device calculates a capacity retention rate from the calculated full charge capacity and an initial full charge capacity, and holds the capacity retention rate. The power storage control device calculates a next full charge capacity based on the held capacity retention rate.

### SUMMARY

The present inventors desire to propose a method of appropriately estimating available energy of a secondary battery.

The method for estimating available energy of a secondary battery disclosed here is executed by a computer. The estimation method includes a process of acquiring a change amount of a capacity retention rate of the secondary battery, a process of estimating a change amount of an initial available energy ratio of the secondary battery, and a process of estimating available energy of the secondary battery. In the process of acquiring the change amount of the capacity retention rate, the change amount of the capacity retention rate is acquired based on predetermined information acquired from the secondary battery. In the process of estimating the change amount of the initial available energy ratio, the change amount of the initial available energy ratio is estimated by multiplying the change amount of the capacity retention rate by a coefficient K. In the process of estimating the available energy, the available energy is estimated based on the estimated change amount of the initial available energy ratio of the secondary battery.

According to this estimation method, the available energy of the secondary battery is appropriately estimated.

### BRIEF DESCRIPTION OF THE DRAWINGS

FIG. 1 is a schematic diagram showing a battery system 100;
FIG. 2 is a flowchart showing processing executed in a control device 30;
FIG. 3 is a flowchart showing processing executed in the control device 30;
FIG. 4 is a graph showing an example of a relationship between capacity retention rate and initial available energy ratio;
FIG. 5 is an example of a graph showing a relationship between temperature of a secondary battery and a correction coefficient n for correcting the coefficient K;
FIG. 6 is a flowchart showing processing executed in the control device 30 according to another embodiment; and
FIG. 7 is a conceptual diagram showing a relationship between capacity retention rate and available energy, and each parameter.

### DETAILED DESCRIPTION OF THE PREFERRED EMBODIMENTS

Hereinafter, one embodiment of the technology disclosed here will be described with reference to the drawings. The embodiments described here are naturally not intended to specifically limit the present disclosure. Each drawing is drawn schematically and does not necessarily reflect the actual objects. In addition, the same reference numerals will be appropriately assigned to members and portions that exhibit the same function, and redundant description thereof will be appropriately omitted.

### <Battery System 100>

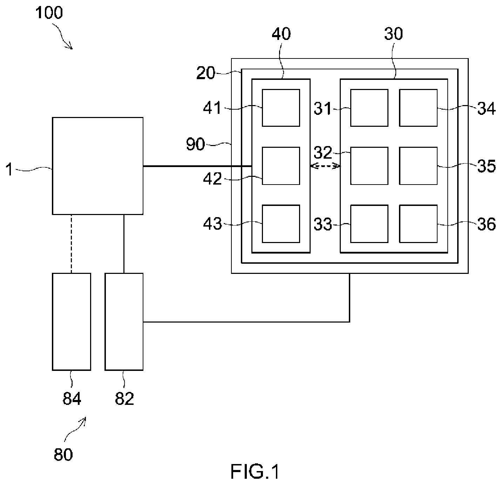

FIG. 1 is a schematic diagram showing the battery system 100. As shown in FIG. 1, the battery system 100 includes a secondary battery 1 and an estimation device 20. The battery system 100 includes a sensor 40. The battery system 100 is also referred to as a battery pack, and is an assembly including, in addition to the secondary battery 1, a configuration for controlling the secondary battery 1, and the like.

In this specification, a "secondary battery" is a power storage device from which electrical energy can be extracted, and is a power storage device that can be repeatedly charged and discharged by the movement of charge carriers between a pair of electrodes (positive electrode and negative electrode) via an electrolyte. The secondary battery includes, for example, a lithium ion secondary battery. A use form of the secondary battery is not particularly limited. The secondary battery may be an assembled battery in which a plurality of secondary batteries (unit cells) are mutually electrically connected. The secondary battery may be, for example, a so-called vehicle-mounted battery that serves as a power source for an electric vehicle. When the secondary battery is used as a vehicle-mounted battery, the secondary battery may be appropriately connected to a charging and discharging device and may be recharged. The secondary battery may be a so-called stationary battery. When the secondary battery is used as a stationary battery, the secondary battery may be connected to a power generation device, system power, or the like.

The secondary battery 1 is connected to connection equipment 80 such as an external load 82 and a charger 84. In this embodiment, the battery system 100 is a vehicle-mounted battery system for electric vehicles. A type of the electric vehicle is not particularly limited. Examples of the electric vehicle to which the battery system 100 can be applied include a plug-in hybrid vehicle (PHEV), a hybrid vehicle (HEV), and an electric vehicle (BEV).

The external load 82 is a load of an electric vehicle, and may be constituted by an electric motor, an inverter, and the like of the vehicle. The battery system 100 is not limited to this form, and the battery system 100 can also be applied to devices other than power storage devices mounted in electric vehicles. The estimation device 20 may be a part of a vehicle-mounted ECU (Electronic Control Unit) 90. The estimation device 20 is not limited to this form, and the estimation device 20 may be another device configured to be communicable with the vehicle-mounted ECU 90. The charger 84 is a device capable of supplying electric power to the secondary battery 1. The secondary battery 1 may be appropriately connected to the charger 84. The electric power supplied from the secondary battery 1 to the external load 82 may be supplied from the charger 84.

The secondary battery 1 may deteriorate over time with the charging and discharging of the secondary battery 1. A deterioration state of the secondary battery 1 may be represented by a capacity retention rate A. The capacity retention rate A is a current full charge capacity Cx expressed as a percentage when an initial (before deterioration) full charge capacity C0 of the secondary battery 1 is 100%. The capacity retention rate A is calculated by Equation 1 based on the initial full charge capacity C0 and the current full charge capacity Cx. The capacity retention rate A (%) is 0 or more and 100 or less. The full charge capacity C is a capacity of constant electric current discharge at 1C at a specific temperature, and is represented by a product of discharge electric current and discharge time. The full charge capacity C is an electric capacity when an SOC (State of Charge) representing a charging rate is 100%. The capacity retention rate A indicating the deterioration state of the secondary battery 1 may decrease with use of the secondary battery 1. In other words, the electric capacity (Ah) that can be extracted from the secondary battery 1 may decrease with use of the secondary battery 1. The deterioration state of the secondary battery 1 may be represented by SOH (State of Health). $A = \left(Cx/C0\right) \times 100$ Equation 1

Incidentally, during use of the battery system 100 and the like, there may be a desire to grasp energy available at the external load 82. However, in order to evaluate the energy available at the external load 82, the current charging rate (SOC) and the capacity retention rate A of the secondary battery 1 are not sufficient. According to the knowledge of the present inventors, in order to calculate the energy available at the external load 82, various calculations are necessary.

For example, when the battery system 100 is used for vehicle mounting in an electric vehicle, in order to calculate a cruising range of the electric vehicle, it is necessary to determine available energy at the external load 82. The vehicle-mounted ECU 90 has limitations in processing capacity of a computing device and the like. For this reason, a capacity for calculating energy available from the secondary battery 1 in the battery system 100 may be limited.

Further, due to deterioration of the secondary battery 1 (a decrease in the capacity retention rate A), the energy available at the external load 82 may decrease. In this case, a calculation that also takes into consideration the deterioration of the secondary battery 1 may be necessary.

Hereinafter, a method for estimating available energy of the secondary battery 1 that is executed by the estimation device 20 will be described together with a configuration of the estimation device 20. The estimation method described below may be executed by a computer.

### <Estimation Device 20>

The estimation device 20 includes a control device 30. The control device 30 includes a first calculator 31, a second calculator 32, a third calculator 33, a fourth calculator 34, a fifth calculator 35, and a memory 36. The control device 30 may be a computer such as an ECU (Electronic Control Unit), a circuit board with a microcomputer, or the like. The computer, for example, performs required functions according to a predetermined program. Each function of the computer is processed by cooperation of a computing device (also called processor, CPU (Central Processing Unit), and MPU (Micro-Processing Unit)) and storage device (memory, hard disk, etc.) of the computer and software. In this embodiment, the control device 30 is realized by an ECU. Each of the components 31 to 36 of the control device 30 may be realized by one or more processors, or may be incorporated in a circuit. The control device 30 is configured to be communicable with the sensor 40. The estimation device 20 is configured to be communicable with the sensor 40. The sensor 40 includes a voltage sensor 41, an electric current sensor 42, and a temperature sensor 43.

The voltage sensor 41 detects a voltage value of the secondary battery 1. The electric current sensor 42 detects an electric current value during charging and discharging of the secondary battery 1. The temperature sensor 43 detects a temperature of the secondary battery 1. When the secondary battery 1 is an assembled battery, the temperature sensor 43 and the voltage sensor 41 may be provided for each unit cell of the secondary battery 1. The voltage sensor 41, the electric current sensor 42, and the temperature sensor 43 can detect the electric current value, voltage value, and temperature of the secondary battery 1, respectively, as analog signals. The electric current value, voltage value, and temperature are detected from the secondary battery 1 over time. Here, the voltage sensor 41, the electric current sensor 42, and the temperature sensor 43 can detect the electric current value, voltage value, and temperature, respectively, at predetermined intervals. Intervals for detecting the electric current value, voltage value, and temperature are not particularly limited. The detected analog signals are converted to digital signals by an A/D converter (not shown) and transmitted to the control device 30. The electric current value, voltage value, and temperature are stored in the memory 36. Each parameter during charging and discharging of the secondary battery 1 may be stored in association with time.

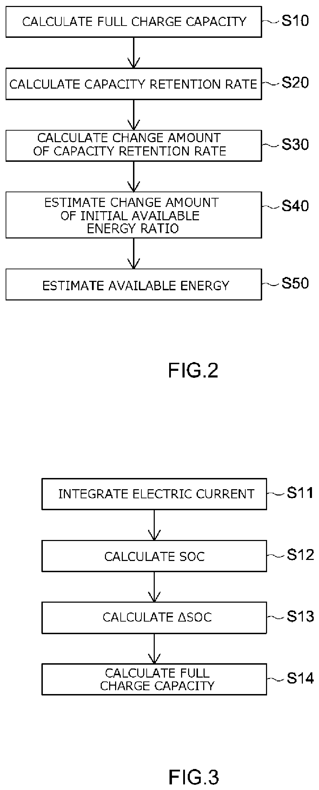

FIGS. 2 and 3 are flowcharts showing processing executed in the control device 30. Here, when an ignition switch (not shown) of a vehicle is turned ON (Step S10), processing by the control device 30 is started. At this time, a signal notifying that the ignition switch has been turned ON may be transmitted from the vehicle-mounted ECU 90 to the control device 30.

In Step S10 (see FIG. 2), the first calculator 31 acquires the current full charge capacity Cx. In this embodiment, the first calculator 31 calculates the full charge capacity Cx using parameters such as an electric current value, a voltage value, and a temperature in a predetermined period. Step S10 includes the following Steps S11 to S14 (see FIG. 3).

As shown in FIG. 3, in Step S11, the charge/discharge electric current within a predetermined period (in this embodiment, within the period when the ignition switch was turned ON last time) is integrated, and an electric current integrated value ΣI is calculated. In Step S12, an SOC is calculated from the current voltage value and temperature after elapse of the above-mentioned predetermined period. As the voltage value and the temperature, those detected by the sensor 40 when the voltage value and the temperature become stable after the ignition switch is turned ON are used. For example, in Step S12, the voltage value and the temperature may be acquired over time, and when a fluctuation per unit time of the voltage value and the temperature becomes lower than a predetermined threshold value, it may be determined that the voltage value and the temperature have stabilized. In Step S13, a difference ΔSOC between a calculation result of the SOC before elapse of the above-mentioned predetermined period (previous SOC) and a calculation result of the current SOC is calculated. In Step S14, the full charge capacity Cx is calculated from a comparison between the electric current integrated value ΣI integrated in Step 11 and the ΔSOC calculated in Step 13. The full charge capacity Cx may be calculated, for example, by the following Equation 2. Step S11 may be performed before Step S14, and does not necessarily need to be performed before Step S12. $Cx = ΣI / ΔSOC \times 100$ Equation 2

The relationship between the voltage value and the SOC when calculating the SOC (Step S12) depends on the temperature. A table for converting the voltage value to the SOC at each temperature, which is acquired in advance through tests and the like, may be stored in the memory 36. In Step S12, the SOC may be calculated from the voltage value and the temperature by this table.

In Step S20 (see FIG. 2), the second calculator 32 acquires the capacity retention rate A. The capacity retention rate A is calculated by the above-mentioned Equation 1 based on the current full charge capacity Cx and the initial full charge capacity C0.

In Step S30 (see FIG. 2), the third calculator 33 acquires a change amount ΔAx of the capacity retention rate A of the secondary battery 1. The change amount ΔAx of the capacity retention rate A is calculated by the following Equation 3 from the initial full charge capacity C0 and the current full charge capacity Cx. The change amount ΔAx of the capacity retention rate A may be calculated by the following Equation 4. The change amount ΔAx (%) is 0 or more and 100 or less. In this embodiment, the change amount ΔAx is calculated from the current full charge capacity Cx acquired based on information such as the electric current value, the voltage value, and the temperature acquired from the secondary battery 1. $ΔAx = \left(C0-Cx\right) / C 0 \times 100$ Equation 3 $ΔAx = 100 - A$ Equation 4

In Step S40 (see FIG. 2), the fourth calculator 34 calculates an estimated value of a change amount ΔBx of an initial available energy ratio B of the secondary battery 1. Here, "the initial available energy ratio B of the secondary battery 1" is energy Ex currently available in the secondary battery 1 expressed as a percentage when energy E0 available in the initial (before deterioration) secondary battery 1 having the full charge capacity C0 is 100%. The energy Ex available in the secondary battery 1 is energy available in the current secondary battery 1 when discharged from full charge (SOC 100%) to complete discharge (SOC 0%). The initial available energy ratio B of the secondary battery 1 is calculated by the following Equation 5. The initial available energy ratio B (%) of the secondary battery 1 is 0 or more and 100 or less. $B = Ex / E 0 \times 100$ Equation 5

The change amount ΔBx of the initial available energy ratio B of the secondary battery 1, and the initial available energy E0, and the current available energy Ex have relationships of the following Equations 6 and 7. $ΔBx = \left(E0-Ex\right) / E 0 \times 100$ Equation 6 $ΔBx = 100 - B$ Equation 7

According to the knowledge of the present inventors, with deterioration of the secondary battery 1, the initial available energy ratio B and the capacity retention rate A do not decrease to the same extent. For example, when the secondary battery 1 deteriorates, the internal resistance of the secondary battery 1 may increase. When the internal resistance increases, the voltage value also rises with respect to the electric current value, so that usable energy (electric power) decreases. In this case, the initial available energy ratio B of the secondary battery 1 may decrease more greatly than the capacity retention rate A.

The fourth calculator 34 acquires (calculates) an estimated value of the change amount ΔBx of the initial available energy ratio B of the secondary battery 1 (hereinafter, also simply referred to as "change amount ΔBx") by multiplying the change amount ΔAx of the capacity retention rate A by a coefficient K. The change amount ΔBx is represented by the following Equation 8. The estimated value ΔBx (%) of the change amount is 0 or more and 100 or less. $ΔBx = K \times ΔAx$ Equation 8

In Step S50 (see FIG. 2), the fifth calculator 35 estimates the available energy Ex of the secondary battery 1 based on the estimated change amount ΔBx of the initial available energy ratio B of the secondary battery 1. Here, the change amount ΔBx and the available energy E0, Ex have the relationship of the above-mentioned Equation 5. Therefore, when the change amount ΔBx is estimated, the available energy Ex of the current secondary battery 1 can be estimated.

In the above-described embodiment, the estimation device 20 includes a process of acquiring the change amount ΔAx of the capacity retention rate A of the secondary battery 1 (Step S30), a process of estimating the change amount ΔBx of the initial available energy ratio B of the secondary battery 1 (Step S40), and a process of estimating the available energy of the secondary battery 1 based on the estimated change amount ΔBx of the initial available energy ratio B of the secondary battery 1 (Step S50). The capacity retention rate A is acquired based on predetermined information (in this embodiment, electric current value, voltage value, temperature, etc.) acquired from the secondary battery 1. The change amount ΔBx of the initial available energy ratio B of the secondary battery 1 is estimated by multiplying the change amount ΔAx of the capacity retention rate A by the coefficient K. As described above, the initial available energy ratio B and the capacity retention rate A do not decrease to the same extent. Therefore, when estimating the current initial available energy ratio B in the secondary battery 1, a calculation process different from the capacity retention rate A is required. In the above-described estimation method, the change amount ΔBx of the initial available energy ratio B is calculated simply by multiplying the estimated change amount ΔAx of the capacity retention rate A by the coefficient K, the current initial available energy ratio B of the secondary battery 1 is estimated, and the available energy Ex is estimated. According to the above-described estimation method, the available energy Ex can be estimated while reducing a processing load on the estimation device 20.

The coefficient K may be a predetermined value. The coefficient K can be fixed by limiting a drive pattern, temperature, and the like. Fixing K is effective in reducing calculation processing. The coefficient K may be calculated in advance by tests and the like, and stored in the memory 36. The test may be performed, for example, using a test secondary battery having the same configuration as the secondary battery 1. Although not particularly limited, the coefficient K can be calculated by determining a relationship between the capacity retention rate and the initial available energy ratio for test secondary batteries having various degrees of deterioration.

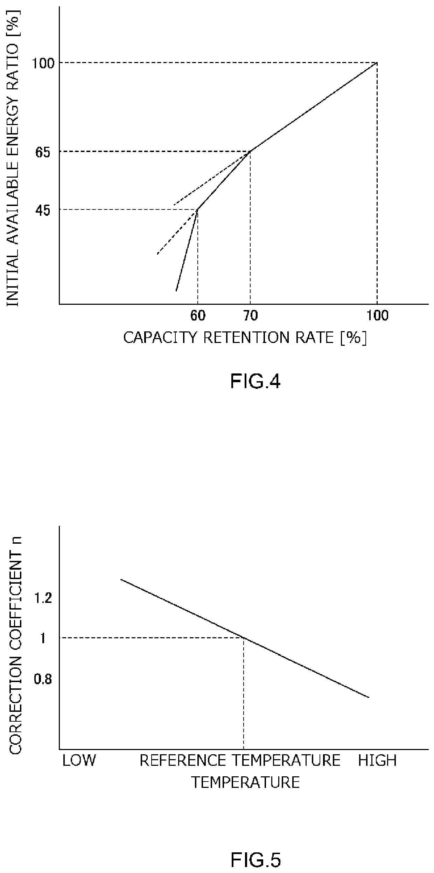

According to the test of the present inventors, the degree of decrease in the capacity retention rate and the degree of decrease in the initial available energy ratio were not constant, but it was confirmed that the capacity retention rate and the initial available energy ratio were generally in a proportional relationship. At the same time, it was also confirmed that there is a stage at which the available energy starts to decrease greatly with respect to the decrease in the capacity retention rate. FIG. 4 is a graph showing an example of a relationship between the capacity retention rate and the initial available energy ratio. As shown in FIG. 4, when the capacity retention rate is 70% and 60%, the decrease in the available energy begins to become larger with respect to the decrease in the capacity retention rate, respectively. Therefore, the coefficient K is different for a capacity retention rate of 70 to 100%, a capacity retention rate of 60 to 70%, and a capacity retention rate of 60% or less. In this embodiment, in ascending order, there are the coefficient K1 for a capacity retention rate of 70 to 100%, the coefficient K2 for a capacity retention rate of 60 to 70%, and the coefficient K3 for a capacity retention rate of 60% or less (K1 < K2 < K3). As described above, the coefficient K may be a different value depending on the capacity retention rate. By using the different coefficient K depending on the capacity retention rate, the accuracy of calculating the available energy can be improved. The relationship between the capacity retention rate and the available energy may differ depending on the type, configuration, and the like of the secondary battery. Therefore, the stage at which the available energy begins to decrease greatly with respect to the decrease in the capacity retention rate is not necessarily confirmed.

Further, according to the test of the present inventors, the relationship between the capacity retention rate and the available energy was different depending on the temperature. The coefficient K may be corrected according to the temperature of the secondary battery when the available energy of the secondary battery is estimated. FIG. 5 is an example of a graph showing a relationship between the temperature of the secondary battery and a correction coefficient n for correcting the coefficient K. As shown in FIG. 5, the higher the temperature of the secondary battery, the lower the value of the correction coefficient n, and the lower the temperature of the secondary battery, the higher the value of the correction coefficient n. The correction coefficient n can be set to be 1 at a reference temperature (for example, the temperature when the coefficient K was calculated). In this embodiment, the correction coefficient n is multiplied by the coefficient K used when estimating the change amount of the initial available energy ratio of the secondary battery. Therefore, it can be estimated that the higher the temperature of the secondary battery, the higher the available energy, and the lower the temperature of the secondary battery, the lower the available energy. By correcting the coefficient K according to the temperature, the accuracy of calculating the available energy can be improved.

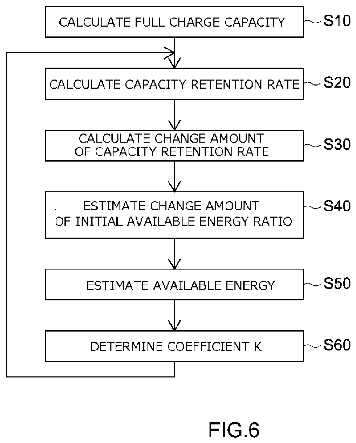

The estimated available energy Ex may be appropriately updated during use of the battery system 100. In the vehicle-mounted battery system 100 for electric vehicles, the available energy Ex may be updated during traveling. FIG. 6 is a flowchart showing processing executed in the control device 30 according to another embodiment. In this embodiment, the processing of Steps S10 to S50 is the same as in the above-described embodiment, so description thereof will be omitted.

In Step S60 (see FIG. 6), the coefficient K is determined based on predetermined information acquired from the secondary battery 1 at a timing when the change amount ΔAx of the capacity retention rate A is acquired. By determining the coefficient K based on information during use of the battery system 100, estimation accuracy of a temporal change of the available energy Ex can be improved. A method of determining the coefficient K is not particularly limited. In this embodiment, the coefficient K is determined by multiple regression analysis. The predetermined information may be an average value of each parameter described below from when the ignition switch is turned ON to the present.

In this embodiment, the information acquired from the secondary battery 1 includes the temperature of the secondary battery 1, the rise rate of the internal resistance of the secondary battery 1, and the SOC. According to the test of the present inventors, these parameters have a large contribution when determining the coefficient K. Therefore, when determining the coefficient K, the coefficient K can be determined including at least one of these parameters. By using these parameters, the coefficient K is appropriately determined, and estimation accuracy of a temporal change of the available energy Ex can be further improved.

In this embodiment, the coefficient K is determined by multiple regression analysis in which temperature, rise rate of internal resistance, and SOC are explanatory variables, and the coefficient K is a dependent variable. The coefficient K for determining the available energy Ex of the secondary battery 1 easily varies due to the voltage value during charging and discharging. The above-mentioned temperature, rise rate of internal resistance, and SOC have a large contribution to the voltage of the secondary battery 1. The higher the rise rate of the internal resistance of the secondary battery 1, the more the deterioration of the secondary battery 1 progresses and the internal resistance increases. The lower the rise rate of the internal resistance of the secondary battery 1, the more the deterioration of the secondary battery 1 is suppressed, and the internal resistance is less likely to increase. The higher the temperature of the secondary battery 1, the lower the internal resistance tends to be, and the lower the temperature of the secondary battery 1, the higher the internal resistance tends to be. The higher the internal resistance, the greater the voltage drop during discharging. In addition, the lower the SOC of the secondary battery, the lower the voltage value of the secondary battery 1. By using the temperature, rise rate of internal resistance, and SOC as explanatory variables, the coefficient K can be more appropriately determined. As a result, estimation accuracy of a temporal change of the available energy Ex can be further improved.

In order to determine the coefficient K, in addition to the temperature, rise rate of internal resistance, and SOC, various parameters may be added as explanatory variables for the multiple regression analysis. In this embodiment, the electric current value (absolute value) and the charge/discharge ratio are further added as explanatory variables. For example, the higher the electric current value during discharging, the greater the voltage drop of the secondary battery 1. The charge/discharge ratio is a ratio of the total of electric current values during charging to the total of electric current values during discharging from when the ignition switch is turned ON to the present (total of electric current values during charging / total of electric current values during discharging). The higher the charge/discharge ratio, the easier the voltage value of the secondary battery 1 rises due to charging.

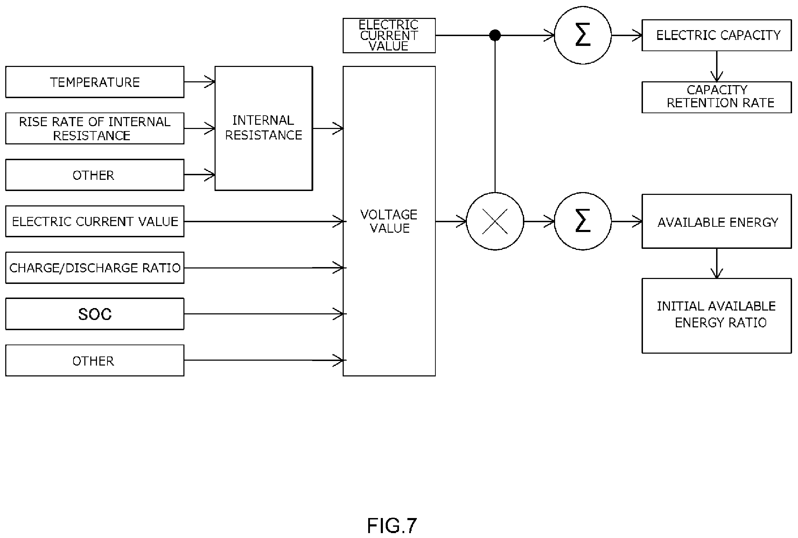

FIG. 7 is a conceptual diagram showing a relationship between the capacity retention rate and available energy, and each parameter. In the embodiment shown in FIG. 7, the electric current value is integrated, and the electric capacity and capacity retention rate are estimated. From the temperature and the rise rate of internal resistance, the internal resistance is estimated. From the internal resistance, electric current value, charge/discharge ratio, and SOC, the voltage value is estimated. From the voltage value and the electric current value, the electric power is estimated. The electric power is integrated, and the available energy and initial available energy ratio are estimated. By adding these parameters having a large influence on the voltage value as explanatory variables, the coefficient K is more appropriately determined. As a result, estimation accuracy of a temporal change of the available energy Ex can be further improved.

In this embodiment, a relational expression (Equation 9) of multiple regression analysis obtained from the test conditions and test results exemplified in Table 1 is stored in the memory 36. After the ignition switch is turned ON, the coefficient K may be updated at any time based on this relational expression. The relational expression may be obtained from the conditions and results of the test for determining the relationship between the capacity retention rate and the initial available energy ratio described above. Here, explanatory variable A is temperature, explanatory variable B is a rise rate of internal resistance, explanatory variable C is an absolute value of electric current value, explanatory variable D is a charge/discharge ratio, and explanatory variable E is a value calculated based on SOC. Each explanatory variable is not particularly limited as long as it is a value calculated from each parameter. Each explanatory variable may be, for example, a value calculated by numerical processing such as a reciprocal of each parameter. Each explanatory variable may be calculated by a different calculation method. α, β, γ, δ, ε are regression coefficients of each explanatory variable. ζ is an intercept (constant) of the regression model. In Table 1, Tx, Ux, Kx are represented by the following Equations 10 to 12, respectively. x is a test number of each test. In each test, conditions other than each explanatory variable match. The explanatory variables are not limited to the above-mentioned parameters, and other parameters may be used. $K = α \times A + β \times B + γ \times C + δ \times D + ε \times E + ζ$ Equation 9 $Tx = Rx / Px \times 100$ Equation 10 $Ux = Sx / Qx \times 100$ Equation 11 $Kx = \left(100-Ux\right) / \left(100-Tx\right)$ Equation 12

### [Table 1]

**Table 1**

| Test Number | Test Conditions | | | | |
|---|---|---|---|---|---|
| | Temperature | Internal Resistanc e Rise Rate | Electric Current | Charge/ Discharge Ratio | SOC |
| 1 | A1 | B1 | C1 | D1 | E1 |
| 2 | A2 | B2 | C2 | D2 | E2 |
| 3 | A3 | B3 | C3 | D3 | E3 |
| 4 | A4 | B4 | C4 | D4 | E4 |
| ... | ... | ... | ... | ... | ... |

**Table 1**

| Test Number | Test Results | | | | | | |
|---|---|---|---|---|---|---|---|
| | Before Deterioration | | After Deterioration | | | | K |
| | Capacity (Ah) | Available Energy (Wh) | Capacity (Ah) | Available Energy (Wh) | Capacity Retention Rate (%) | Initial Available Energy Ratio (%) | |
| 1 | P1 | Q1 | R1 | S1 | T1 | U1 | K1 |
| 2 | P2 | Q2 | R2 | S2 | T2 | U2 | K2 |
| 3 | P3 | Q3 | R3 | S3 | T3 | U3 | K3 |
| 4 | P4 | Q4 | R4 | S4 | T4 | U4 | K4 |
| ... | ... | ... | ... | ... | ... | ... | ... |

Returning to Step S20, the coefficient K used in Step S40 is updated to the coefficient K determined in Step S60. The current capacity retention rate A is calculated. The processing from Step S30 onward is repeated, and the current available energy Ex is estimated based on the updated coefficient K and the change amount ΔAx of the capacity retention rate. As described above, the current available energy Ex may be updated at any time during use of the battery system 100. When updating the available energy is not necessary, the above-mentioned Step S60 is not essential.

The above-described estimation method can be realized by the estimation device 20. The estimation device 20 includes a non-transitory computer-readable storage medium storing a program for executing the above-described estimation method, and one or more processors capable of executing the program stored in the storage medium.

Various descriptions have been given above regarding the technology disclosed here. Unless specifically mentioned, the embodiments and the like described here do not limit the present disclosure. In addition, the technology disclosed here can be variously modified, and unless a specific problem arises, each component and each process mentioned here can be appropriately omitted or can be appropriately combined. Further, the present specification includes disclosure described in each of the following items.

### Item 1:

A method for estimating available energy of a secondary battery, the method being executed by a computer, the method comprising:
acquiring a change amount of a capacity retention rate of the secondary battery based on predetermined information acquired from the secondary battery;
estimating a change amount of an initial available energy ratio of the secondary battery by multiplying the change amount of the capacity retention rate by a coefficient K; and
estimating available energy of the secondary battery based on the estimated change amount of the initial available energy ratio of the secondary battery.

### Item 2:

The estimation method according to Item 1, wherein the coefficient K is a predetermined value.

### Item 3:

The estimation method according to Item 2, wherein the coefficient K is a different value depending on the capacity retention rate.

### Item 4:

The estimation method according to Item 2 or 3, wherein the coefficient K is corrected according to a temperature of the secondary battery.

### Item 5:

The estimation method according to any one of Items 1 to 4, configured such that the coefficient K is determined based on predetermined information acquired from the secondary battery at a timing when the change amount of the capacity retention rate is acquired.

### Item 6:

The estimation method according to Item 5, wherein the predetermined information includes at least one of a value calculated based on a rise rate of internal resistance of the secondary battery, a value calculated based on a temperature of the secondary battery, and a value calculated based on an SOC of the secondary battery.

### Item 7:

The estimation method according to Item 6, wherein the coefficient K is determined by multiple regression analysis in which at least the rise rate of internal resistance of the secondary battery, the temperature of the secondary battery, and the SOC of the secondary battery are explanatory variables, and the coefficient K is a dependent variable.

### Item 8:

A non-transitory computer-readable storage medium storing a program for causing a computer to execute the method according to any one of Items 1 to 7.

### Item 9:

A device for estimating available energy of a secondary battery, the device comprising:
a non-transitory computer-readable storage medium storing a program for causing a computer to execute the method according to any one of Items 1 to 7; and
one or more processors capable of executing the program stored in the memory.

### Item 10:

A battery system comprising:
a secondary battery; and
the estimation device according to Item 9.

## Claims

1. A method for estimating available energy of a secondary battery (1), the method being executed by a computer, the method comprising:
acquiring (S30) a change amount of a capacity retention rate of the secondary battery (1) based on predetermined information acquired from the secondary battery (1);
estimating (S40) a change amount of an initial available energy ratio of the secondary battery (1) by multiplying the change amount of the capacity retention rate by a coefficient K; and
estimating (S50) available energy of the secondary battery (1) based on the estimated change amount of the initial available energy ratio of the secondary battery (1).

2. The estimation method according to claim 1, wherein the coefficient K is a predetermined value.

3. The estimation method according to claim 2, wherein the coefficient K is a different value depending on the capacity retention rate.

4. The estimation method according to claim 2 or 3, wherein the coefficient K is corrected according to a temperature of the secondary battery (1).

5. The estimation method according to any one of claims 1 to 3, wherein the coefficient K is configured to be determined based on predetermined information acquired from the secondary battery (1) at a timing when the change amount of the capacity retention rate is acquired.

6. The estimation method according to claim 5, wherein the predetermined information includes at least one of a value calculated based on a rise rate of internal resistance of the secondary battery (1), a value calculated based on a temperature of the secondary battery (1), and a value calculated based on an SOC of the secondary battery (1).

7. The estimation method according to claim 6, wherein the coefficient K is determined by multiple regression analysis in which at least a value calculated based on the rise rate of internal resistance of the secondary battery (1), a value calculated based on the temperature of the secondary battery (1), and a value calculated based on the SOC of the secondary battery (1) are explanatory variables, and the coefficient K is a dependent variable.

8. A non-transitory computer-readable storage medium storing a program for causing a computer to execute the method according to any one of claims 1 to 3.

9. A device (20) for estimating available energy of a secondary battery (1), the device (20) comprising:
a non-transitory computer-readable storage medium storing a program for causing a computer to execute the method according to any one of claims 1 to 3; and
one or more processors capable of executing the program stored in the memory.

10. A battery system (100) comprising:
a secondary battery (1); and
the estimation device (20) according to claim 9.
